**Europäisches Patentamt**

**European Patent Office**

**Office européen des brevets**

(11) Veröffentlichungsnummer: **0 202 544**
**A2**

## (12) EUROPÄISCHE PATENTANMELDUNG

(21) Anmeldenummer: **86106276.8**

(22) Anmeldetag: **07.05.86**

(51) Int. Cl.⁴: **H05K 3/44**

(30) Priorität: **17.05.85 DE 3517796**

(43) Veröffentlichungstag der Anmeldung:
**26.11.86 Patentblatt 86/48**

(84) Benannte Vertragsstaaten:
**DE FR GB IT NL SE**

(71) Anmelder: **HOECHST AKTIENGESELLSCHAFT**
**Postfach 80 03 20**
**D-6230 Frankfurt am Main 80(DE)**

(72) Erfinder: **Seibel, Markus, Dr. Dipl.-Chem.**
**Am Rosengarten Nr. 16**
**D-6500 Mainz 1(DE)**

(54) **Verfahren zur Herstellung von elektrisch isolierendem Basismaterial für die Fertigung von durchkontaktierten Leiterplatten.**

㊗ Es wird ein Verfahren zur Herstellung eines elektrisch isolierenden Basismaterials für die Herstellung von gelochten durcchkontaktierten Leiterplatten mit einem Metallkern beschrieben, bei dem auf den vorgelochten Metallkern durch ein elektrostatisches Sprühverfahren eine strahlungshärtbare Isolierstoffschicht aufgebracht und durch Bestrahlung oder Wärme vorgehärtet, durch Elektrophorese mit einer weiteren dünnen, thermisch härtbaren Isolierstoffschicht überzogen, die Schicht durch Erwärmen getrocknet und ebenfalls teilweise ge-härtet wird, so daß sie nicht mehr fließfähig, aber noch reaktiv ist, gegebenenfalls weitere härtbare Isolierschichten aufgebracht werden und schließlich der gesamte Isolierstoffüberzug thermisch ausgehärtet wird. Die erhaltenen Überzüge sind dicht und auch an den Lochwandungen von gleichmäßiger Stärke.

EP 0 202 544 A2

## Verfahren zur Herstellung von elektrisch isolierendem Basismaterial für die Fertigung von durchkontaktierten Leiterplatten

Die Erfindung betrifft ein Verfahren zur Herstellung eines elektrisch isolierenden Basismaterials für die Fertigung von gelochten durchkontaktierten Leiterplatten mit einem Metallkern.

Die Verwendung von Isolierstoffplatten mit einem Metallkern als Basismaterial für Leiterplatten ist bekannt. Die als Kern dienende Metallplatte kann z. B. aus Eisen oder -wegen seines geringen Gewichts und seiner guten Wärmeleitfähigkeit bevorzugt -aus Aluminium bestehen. Wenn die Platte mit Löchern zum Anbringen von Durchkontaktierungen versehen werden soll, werden diese im allgemeinen schon vor dem Aufbringen des Isolierstoffs hergestellt, z. B. gebohrt. Die gleichmäßige und porenfreie Isolierung, vor allem der Lochwandungen, ist eine wesentliche Voraussetzung für die Brauchbarkeit solcher Produkte. Wegen der gewünschten Wärmeableitung sollen die Isolierschichten möglichst dünn sein, wobei aber die Porenfreiheit gewahrt bleiben muß. Es sind viele Verfahren bekannt, die sich mit diesem Problem beschäftigen.

Gemäß der US-A 3 296 099 wird eine mit vorgestanzten Löchern versehene Metallplatte mit einem Epoxidpulver im Wirbelbett-Sinterverfahren überzogen. Dabei wird die gesamte Oberfläche einschließlich der Lochwandungen mit Epoxidharz überzogen. Nachteilig ist die stundenglas-bzw. sanduhrartige Form der Isolierschicht innerhalb der Löcher; zur Plattenmitte hin ist der Überzug stets dicker als an den Enden der Löcher. Um die Lochkanten ausreichend zu isolieren, ist es notwendig, sehr dicke Isolierschichten im Bereich der Lochmitte in Kauf zu nehmen. Man muß deshalb von relativ großen Lochdurchmessern im Metallkern ausgehen. Dadurch ist wiederum nur eine relativ geringe Flächenausnutzung beim Aufbau von Leiterplatten möglich. Die Entwicklung der modernen Leiterplattentechnik geht jedoch zu Leiterplatten mit immer höherer Leiterzugdichte.

In der DE-A 24 53 788 wird ein Verfahren beschrieben, bei dem Löcher in Aluminiumplatten mit losem thermoplastischem und wärmehärtbarem Kunststoffmaterial gefüllt werden und das Material dann zu festen, die Löcher ausfüllenden Pfropfen verdichtet wird. In diese Propfen werden dann enge Löcher gebohrt, so daß eine mit Isoliermaterial überzogene Lochwandung verbleibt. Dieses Verfahren ergibt zwar zylindrische Löcher, ist aber kompliziert und teuer.

In der DE-C 19 54 973 wird ein Verfahren beschrieben, bei dem die vorgebohrten Aluminiumplatten zuerst mit einer Grundierung aus isolierendem Material versehen und durch Spritzen mit dem eigentlichen wärmehärtbaren Material in 3 bis 10 übereinanderliegenden Schichten überzogen und anschließend die Überzüge wärmegehärtet werden. Bei diesem Verfahren erweicht zunächst, ebenso wie beim Wirbelsinterverfahren, der Isolierstoff beim Erwärmen, erfließt und wird an den Lochkanten verdünnt (Stundenglaseffekt). Durch die mehrfachen Überzüge kann dies nur zum Teil kompensiert werden, auch wird der Beschichtungsprozeß hierdurch sehr aufwendig.

Ein weiteres bekanntes Beschichtungsverfahren ist das elektrostatische Aufsprühen. Hierbei werden an den Lochwandungen Schichten erzeugt, deren Dicke mit der Entfernung von der Lochkante abnimmt, da das elektrische Feld durch das Metall der Platte abgeschirmt wird. Der Effekt wird um so ausgeprägter, je dicker die Metallplatte und je enger der Lochdurchmesser ist. Die Isolierstoffüberzüge müssen aber porenfrei sein. Diese Forderung läßt sich mit zunehmender Schichtdicke besser erfüllen. Es liegt aber im Wesen des elektrostatischen Sprühbeschichtungsverfahrens, daß man damit, besonders in den Löchern, keine gleichmäßigen und vor allem porenfreien Überzüge erhält.

Das weiterhin bekannte elektrophoretische Beschichtungsverfahren führt zu relativ porenfreien und gleichmäßigen Überzügen. Um aber die Wanderung der Partikel zur Elektrode zu ermöglichen, ist deren Beladung mit Ionen erforderlich. Hierdurch werden jedoch die Isolationseigenschaften der Überzüge, vor allem der Volumen-und Oberflächenwiderstand, gemindert.

Eine elektrophoretische Beschichtung von anodisiertem Aluminium mit metallorganischen wärmehärtbaren Verbindungen wird in der EP-A 58 023 beschrieben. Da die dort verwendeten Verbindungen keine leitfähig machenden ionischen Gruppen enthalten, ist es notwendig, hohe Spannungen und lange Beschichtungszeiten anzuwenden. Dort werden z. B. 500 bis 10000 Volt und 30 bis 120 Minuten angegeben. Das ist sehr aufwendig und riskant.

Es ist im übrigen sehr schwierig, das abzuscheidende Leiterbahnmetall haftfest mit den genannten Isolierstoffen zu verbinden. Eine Ätzung mit Chromsäure, wie sie sonst üblich ist, ist bei den hier verwendeten Substanzen wenig wirksam.

Gemäß der DE-A 30 47 287 wird zur besseren Verankerung des Leitmetalls auf der Isolierstoffoberfläche eine Verankerungs-bzw. Klebstoffschicht aufgebracht. Diese Schicht wird nur auf die ebenen Hauptflächen des Basismaterials aufgebracht, nicht auf die Oberflächen der Lochwandungen. Die Metallschicht weist deshalb an den Wandungen eine geringere Haftung auf, was besonders beim Lötprozeß nachteilig sein kann. Der Grund für diese Verfahrensweise besteht darin, daß im Stadium der Herstellung des Basismaterials die Lage der Bohrungen für die Schaltung noch nicht bekannt und die nachträgliche Beschichtung der Lochwandungen mit Kleber schwierig und teuer ist.

Aus den genannten Gründen haben sich bisher perforierte Leiterplatten mit Metallkern in der Technik noch nicht durchgesetzt, obwohl dafür ein technisches Bedürfnis besteht. Vor allem wäre es erwünscht, die mit solchen Platten erreichbare hohe thermische und mechanische Festigkeit sowie die gute Wärmeleitfähigkeit zu nutzen, die eine dichtere Anordnung von Leiterbahnen und Bauteilen erlaubt.

Aufgabe der Erfindung ist es, ein einfacheres und wirtschaftlicheres Verfahren zur Fertigung von gelochtem Basismaterial für gedruckte Schaltungen mit Metallkern vorzuschlagen, das eine zuverlässige Isolierung gegenüber dem Metallkern mit einer weitgehend gleichmäßigen porenfreien und möglichst dünnen Isolierstoffschicht -auch in den Löchern und an den Lochkanten -und eine haftfeste Verankerung des Leitmetalls auf der Isolierstoffschicht auf der Plattenoberfläche und an den Lochwandungen erlaubt.

Erfindungsgemäß wird ein Verfahren zur Herstellung eines elektrisch isolierenden Basismaterials für die Herstellung von gelochten durchkontaktierten Leiterplatten mit einem Metallkern vorgeschlagen, bei dem der vorgelochte Metallkern mit einem dünnen, gleichmäßigen, ununterbrochenen Überzug aus einem Isolierstoff überzogen und der Isolierstoff gehärtet wird.

Das erfindungsgemäße Verfahren ist dadurch gekennzeich-net, daß man

a) durch ein elektrostatisches Sprühverfahren eine durch Strahlung oder Wärme polymerisierbare Isolierstoffschicht auf den Metallkern aufbringt und diese durch Bestrahlung oder Erwärmen unvollständig aushärtet,

b) den elektrostatisch beschichteten Metallkern in einem elektrophoretischen, bevorzugt kataphoretischen Tauchbad mit einer thermisch härtbaren Substanz behandelt, die abgeschiedene Substanz durch Erwärmen trocknet und unvollständig härtet und

c) schließlich den gesamten Isolierstoffüberzug thermisch vollständig aushärtet.

Bei der Durchführung des erfindungsgemäßen Verfahrens wird zuerst der Metallkern an den gewünschten Stellen gelocht. Die Löcher können durch Bohren oder Stanzen angebracht werden; soweit möglich, wird das kostengünstigere Stanzen bevorzugt. Die Anordnung der Löcher kann bereits so erfolgen, daß sie nur an den Stellen der später gebrauchten Durchkontaktierungen liegen. Sie kann auch vorzugsweise in einem rasterartigen Muster erfolgen, um später eine unterschiedliche Anordnung von Leiterbahnzügen und Durchkontaktierungen zu ermöglichen. Diese Arbeitsweise ist in der älteren deutschen Patentanmeldung P 34 08 630 beschrieben.

Da durch das Stanzen Grate entstehen, die die spätere Isolation des Metallkerns stören können, müssen diese in einem weiteren Arbeitsschritt z. B. durch Bürsten oder Strahlen mit einem Schleifmittel, vor allem mit Sand, entfernt werden. Das beim Stanzen verwendete Öl wird mittels Lösungsmitteln und wäßrig-alkalischen Beizlösungen entfernt. Wenn Aluminium als Kernmaterial verwendet wird, ist es vorteilhaft, die Oberfläche einschließlich der Lochwandungen mittels bekannter Verfahren, z. B. elektrochemisch, chemisch oder mechanisch, aufzurauhen, sie dann anodisch zu oxydieren und die Oxidschicht in heißem Wasser zu verdichten bzw. zu versiegeln. Eisenplatten können in bekannter Weise phosphatiert werden. Um die Reinheit und Gleichmäßigkeit der Oberflächen zu erhöhen, kann noch mit Ultraschall in einem Reinigungsbad nachbehandelt werden.

Als nächster Schritt wird mittels eines Sprühverfahrens eine härtbare Isolierschicht aufgebracht, wobei ein flüssiger Lack in Form von feinsten Tröpfchen auf der Oberfläche einschließlich der Lochwandungen niedergeschlagen wird. Vorzugsweise wird ein elektrostatisches Sprühverfahren eingesetzt. Der Lack kann teilweise oder ganz als Lösung, Suspension oder Dispersion vorliegen; er kann vinylgruppenhaltige Monomere und ein Epoxidharz und ggf. einen Härter enthalten. Die elektrostatisch aufgebrachte Schicht hat im allgemeinen je Auftrag ein Schichtgewicht im Bereich von 1 bis 20, vorzugsweise von 4 bis 16 g/m².

Eine weitere Schicht aus einem thermisch härtbaren Isolierstoff wird aus einem wäßrigen, elektrophoretisch -bevorzugt kataphoretisch -arbeitenden Tauchlackierbad aufgebracht, der dann durch Erwärmen vom Restwasser befreit und in solchem Maße teilweise vernetzt wird, daß er nicht mehr fließfähig, aber noch reaktiv ist. Als Lacksubstanz kann z. B. ein modifiziertes Epoxidharz-Amin-Adduct in Kombination mit einem aktivierte Estergruppen enthaltenden Oligoester eingesetzt werden.

Geeignete Lacksubstanzen sind z. B. in der EP-A 82 291 beschrieben. Diese Schicht ist im allgemeinen wesentlich dünner als die erste Schicht und hat vorzugsweise ein Schichtgewicht von etwa 0,05 bis 5, insbesondere 0,1 bis 1 g/m².

Mit Vorteil wird, wie oben beschrieben, die erste Schicht elektrostatisch aufgebracht, mit UV-Licht oder durch mäßiges Erwärmen, z. B. wenige Minuten auf etwa 80 bis 120°C, polymerisiert und dadurch vorgehärtet, so daß diese Schicht auch beim Erwärmen auf höhere Temperaturen nicht mehr fließfähig ist, sich aber noch beim Aushärten mit weiteren Schichten reaktiv verbinden kann. Die danach kataphoretisch abgeschiedene Schicht bewirkt dann vor allem ein Schließen von Poren und Fehlstellen der ersten Schicht. Deshalb ist für diese Schicht, wie oben angegeben, nur ein geringes Schichtgewicht erforderlich, so daß in der gesamten Isolierschicht nur relativ geringe Mengen der weniger gut isolierenden kataphoretisch aufgebrachten Lacksubstanz enthalten sind. In dieser Weise hergestellte Beschichtungen sind porenfrei und deshalb nach Abscheidung einer Kupferschicht bis zu Spannungen von einigen hundert Volt durchschlagsfest. Dies wird ohne die kataphoretische Behandlung nicht erreicht. Nur durch Aufsprühen hergestellte Isolierstoffüberzüge werden auch bei mehrmaliger Wiederholung nicht durchschlagsfest. Von jeder Beschichtungsart, insbesondere der elektrostatischen Beschichtung können mehrere Schichten aufgebracht werden, so daß die gesamte Isolierstoffschicht ein Gewicht im Bereich von etwa 10 bis 100 g/m² erhält. Die kataphoretische Tauchbeschichtung kann nach irgendeiner der elektrostatischen Beschichtungen erfolgen. Vorzugsweise wird nach der letzten kataphoretischen Beschichtung noch mindestens eine elektrostatische Sprühbeschichtung durchgeführt, da die Verankerung der später aufzubringenden Metall-, insbesondere Kupferschicht auf dieser Schicht besser ist.

Beim Aufbringen des elektrostatisch aufgesprühten Lacks muß verhindert werden, daß die Lackschicht fließt; einmal weil dadurch die Isolierung an den Stellen, von denen der Lack abfließt, geschwächt wird; zum anderen weil durch unerwünschtes Verfließen der Lackschicht, z. B. infolge der Schwerkraft, die Löcher deformiert werden.

Dieses Ziel wird dadurch erreicht, daß man dem Lack neben der Lackharzsubstanz radikalisch polymerisierbare Vinylverbindungen und Photoinitiatoren zusetzt und die aufgesprühte Lackschicht nach jedem Auftrag durch Bestrahlen mit ultraviolettem Licht oder durch Erwärmen in Gegenwart eines thermisch aktivierbaren Polymerisationskatalysators härtet. Zweckmäßig wird der Infrarotanteil der Strahlungsquelle herausgefiltert, um ein unerwünschtes Erwärmen und Verfließen des Lacks während der Bestrahlung zu verhindern.

Als radikalisch polymerisierbare Vinylverbindungen sind einfach oder mehrfach ethylenisch ungesättigte Verbindungen geeignet, wie sie üblicherweise zur Herstellung von photopolymerisierbaren Gemischen oder Lacken verwendet werden. Es sind insbesondere Acryl-und Methacrylsäureester von ein-und mehrwertigen Alkoholen geeignet. Die Alkohole können selbst noch funktionelle Gruppen, z. B. Epoxygruppen, enthalten, die an einer thermischen Vernetzungsreaktion teilnehmen können. Als Photoinitiatoren werden bekannte Verbindungen eingesetzt, die im nahen Ultraviolett- oder im kurzwelligen sichtbaren Spektralbereich empfindlich sind und zur Bildung von Radikalen angeregt werden, z. B. Benzophenonderivate, Benzoinderivate, Mehrkernchinone, bestimmte Mehrkernheterocyclen, wie Acridin-, Phenazin-und Chinazolinderivate, sowie durch Trichlormethylgruppen substituierte Heterocyclen. Wenn eine thermische Polymerisation bei der Vorhärtung erfolgen soll, werden übliche durch Wärme aktivierbare Katalysatoren, wie Dicumylperoxid oder Azodiisobutyronitril, zugesetzt. Der Lack enthält vorzugsweise noch Verbindungen, die durch Erwärmen vernetzbar sind, z. B. Kombinationen von Epoxidharzen und Härtern. Diese Verbindungen werden so gewählt, daß sie erst bei höheren Temperaturen, als sie für die Polymerisation erforderlich sind, aktiviert werden. Die Vernetzung erfolgt im allgemeinen in einem Temperaturbereich von 150 bis 250 °C.

Es ist zweckmäßig, dem zu versprühenden Lack ein leicht flüchtiges Lösungs-bzw. Verdünnungsmittel zuzusetzen. Das erlaubt einmal eine genaue Dosierung beim Versprühen und außerdem eine rasche Verdunstung eines Teils des Lösungsmittels schon während des Sprühvorgangs, so daß die Lacktröpfchen beim Auftreffen auf die Oberfläche bereits eine wesentlich höhere Konzentration und Viskosität haben. Die Viskosität wird zusätzlich durch die Verdunstungskälte gesteigert, so daß auf diese Weise ein unerwünschtes Abfließen des Lacks vor dem vollständigen Trocknen praktisch ganz verhindert werden kann.

Zur Verbesserung der Haftung zwischen Isolierschicht und dem später abzuscheidenden Metall -im allgemeinen Kupferkann dem Isolierlack ein Butadienpolymeres als Verankerungsmittel zugesetzt werden. Verwendbare Verankerungsmittel sind synthetische Dienkautschuke und kautschukfreie Polymere. Beispiele für verwendbare synthetische Dienkautschuke sind Butadienpolymerisate, Butadien/Acrylnitril-Mischpolymerisate, Isoprenkautschuk, Chloroprenkautschuk, Acrylnitril/Butadien/Styrol-Terpolymerisate und Mischungen aus mindestens zwei der genannten synthetischen Kautschuke. Das den synthetischen Dienkautschuk enthaltende oder aus diesem bestehende Verankerungsmittel gestattet die spätere feste Bindung einer leitenden Schicht an das Substrat. Der synthetische Dienkautschuk sollte in einer solchen Menge zum Einsatz gelangen, daß sein Gewicht, bezogen auf die Gesamtmenge an synthetischem Dienkautschuk und wärmehärtbarem Harz in der entsprechenden Schicht, etwa 10 bis 70 Gew.-%, vorzugsweise etwa 15 bis 30 Gew.-%, beträgt.

Die verwendbaren Verankerungsmittel der genannten Arten können anorganische Füllstoffe, wie Kieselsäure, Zirkoniumsilikat oder Magnesiumsilikat enthalten, die die Viskosität erhöhen und als Verstärkungsmaterial wirken.

Bezogen auf die Gesamtmenge Harz kann die Menge an anorganischem Füllstoff 3 bis 50 % betragen. Die Masse kann zusätzlich ein Härtungsmittel, z. B. ein Amin oder Säureanhydrid, enthalten. Ferner kann ihr ein Pigment zugesetzt werden.

Um eine sichere und gleichmäßige Abdeckung und Isolation, vor allem der Lochwandungen zu erzielen, kann es vorteilhaft sein, den Spritzlack in mehreren Schritten nacheinander aufzutragen, wobei vorteilhaft nach jedem Auftrag eine Härtung durch Polymerisation erfolgen sollte. Die Lackzusammensetzung der einzelnen Schichten kann jedesmal die gleiche sein; sie kann aber auch abgeändert werden. So genügt es z.B., das haftungsverbessernde Butadiencopolymere nur in die oberste Schicht einzubringen.

Nach der Polymerisation kann noch ein thermischer Härtungsschritt angeschlossen werden, der aber nicht bis zur vollständigen thermischen Aushärtung der jeweiligen Epoxid-Schicht zu gehen braucht. Es ist sogar günstig, auch hier -wie bei der elektrophoretisch abgeschiedenen Schicht - die thermische Härtung zunächst nur teilweise und die vollständige Aushärtung erst nach der letzten Lackierstufe durchzuführen.

Zur Vorbereitung der chemischen Metallabscheidung werden die Oberflächen in bekannter Weise in organischem Lösungsmittel behandelt. Sie werden dann mit einem Oxidationsmittel behandelt, um sie für die folgenden Metallisiermaßnahmen aufnahmefähig zu machen. Insbesondere dient die Behandlung mit dem Oxidationsmittel dazu, die Schichtoberfläche aufzurauhen. Darüber hinaus wird die Schicht hydrophil gemacht. Verwendbare Oxidationsmittel sind beispielsweise Chromsäure, Salze der Chromsäure, Permanganat, Chromsäure/Fluoroborsäure-Gemische, Chromsäure/Schwefelsäure-Gemische. Insbesondere Gemische aus Chromsäure und Schwefelsäure ermöglichen es, daß das später gebildete leitende Schaltungsmuster fest an die Isolierschicht gebunden wird. Die Oberfläche wird dann mit Bisulfit entgiftet, mit heißer Alkalilauge nachbehandelt und schließlich nochmals in heißem, komplexbildnerhaltigem Wasser ausgewaschen.

Bei allen Verfahrensschritten ist auf eine sorgsame Mitbehandlung der Lochinnenwandungen zu achten, z. B. mit Hilfe von Durchströmungsverfahren.

Die derart vorbehandelten Platten werden in einem handelsüblichen System von Bädern zur stromlosen Abscheidung von Metall -im allgemeinen von Kupfer -behandelt. Dabei wird zunächst die Isolierschichtoberfläche aktiviert, damit bei der folgenden stromlosen Metallisierung eine Metallablagerung erfolgen kann. Insbesondere wird das bei der stromlosen Metallisierung als Katalysator oder Aktivierungsmittel wirkende Palladium auf der Isolierschichtoberfläche abgelagert. Die Aktivierungsbehandlung erfolgt beispielsweise durch Eintauchen des Substrats in eine Palladiumchlorid und Zinn(II)-chlorid enthaltende und mit Salzsäure angesäuerte Lösung. Ferner ist es möglich, die Substratoberfläche mit einer mit Salzsäure angesäuerten Zinn(II)chloridlösung und danach mit einer Palladiumchloridlösung in Berührung zu bringen. Andererseits kann die Substratoberfläche auch mit einer Lösung eines organischen Palladiumkomplexes in Berührung gebracht und danach mit einem schwachen Reduktionsmittel behandelt werden, um auf der Schichtoberfläche metallisches Palladium abzulagern. Das abgelagerte Palladium, d. h. der Katalysator, ermöglicht eine ausreichende Ablagerung des gewünschten Metalls bei der folgenden stromlosen Metallisierung.

Schließlich wird die Substratoberfläche einer stromlosen Metallisierung unterworfen. Verwendbare Bäder sind beispielsweise Kupfer-, Nickel- oder Goldbäder. Besonders gut geeignet ist ein Kupferbad zur stromlosen Verkupferung mit beispielsweise Kupfersulfat, Ethylendiamintetraacetat oder Rochellesalz und Formaldehyd. Erforderlichenfalls können dem Bad Natriumhydroxid, Dipyridyl, Polyethylenoxid und dergleichen zugesetzt werden. In der Regel wird das Bad auf einer Temperatur von 20° bis 75°C gehalten. Während des stromlosen Metallisierens wird der pH-Wert des Bads auf etwa 12,0 bis 13,0 eingestellt.

Bei dem erfindungsgemäßen Verfahren werden bevorzugt beide Seiten des Isolierstoffmaterials und die Lochwandungen mit einer leitfähigen Metallschicht, insbesondere einer Kupferschicht, überzogen. Die Dicke der Metallschicht richtet sich nach der beabsichtigten Weiterverarbeitung. Wenn diese nach dem semiadditiven Verfahren erfolgt, muß die Schicht so beschaffen sein, daß sie in sich zusammenhängend ist und den stromlosen oder bevorzugt galvanischen Aufbau von homogenen und fehlerfreien Metallschichten jeder gewünschten Stärke erlaubt. Im allgemeinen sind hierfür Schichtdicken von etwa 0,1 bis 5μm, bevorzugt 0,2 bis 3μm, ausreichend.

Wenn die Weiterverarbeitung durch den Leiterplattenhersteller subtraktiv erfolgen soll, kann die Schichtdicke im allgemeinen 5 -100μm, vorzugsweise 10 -70μm, betragen.

Es ist zweckmäßig, die Oberfläche des Isoliermaterials einschließlich der Lochwandungen in bekannter Weise durch Reinigen, Anätzen, Bekeimen usw. für die chemische und ggf. galvanische Metallisierung vorzubereiten, da sich zu diesem Zeitpunkt die genannten Schritte in rationeller Weise durchführen lassen. Die Durchführung erfolgt in bekannter Weise durch Erzeugen von fest haftenden Edelmetall-, z. B. Palladium-oder Silberkeimen, wie es z. B. in der DE-A 16 96 603 und der US-A 3 632 388 beschrieben ist, an denen dann stromlos eine zusammenhängende Metallschicht abgeschieden wird.

Die so behandelten Platten tragen sowohl auf ihrer Oberfläche als auch in den Lochwandungen außerordentlich gleichmäßige und fest haftende Isolations-und Kupferschichten. Infolge der vollkommen gleichmäßigen Schichten in den vorgestanzten Löchern sind diese in ihrer Paßgenauigkeit nicht beeinträchtigt, so daß keine Notwendigkeit besteht, die Löcher mit Isolierstoff zuerst voll auszufüllen und dann wieder aufzubohren.

Das Verfahren ist geeignet sowohl für die Einzelplattenfertigung als auch für die Herstellung von Bändern.

Wenn dünne, biegsame Aluminiumbänder von beispielsweise 100μm Dicke für das Verfahren eingesetzt werden, können damit dünne und biegsame, isolierte und durchkontaktierte Materialien gewonnen werden, die sich z. B. zum Einsatz für Mehrlagenschaltungen oder flexible Leiterplatten sehr gut eignen.

Das erfindungsgemäße Basismaterial wird zweckmäßig in Form von Großformaten oder Rollen an den Leiterplattenhersteller geliefert und von diesem in bekannter Weise weiterverarbeitet. Dabei wird die Metall-, z. B. Kupferschicht mit einer Schablone abgedeckt, die dem Aufbau des gewünschten Schaltungsmusters entspricht. Die Schablone kann in bekannter Weise im Siebdruck oder nach dem Photoresistverfahren aufgebracht werden. Dabei ist es zweckmäßig, ein Verfahren zu wählen, mit dem sich die Löcher vollständig überdecken lassen. Für diese als Tenting-Technik bezeichnete Arbeitsweise ist z.B. ein Trocken-Photoresist geeignet.

Die Trockenresistschicht wird auf die Kupferschicht laminiert, wobei alle Löcher überdeckt werden. Danach wird die Resistschicht unter einem Schaltbild belichtet, das die gewünschten Leiterzüge und die benötigten Durchkontaktierungslöcher wiedergibt. Nach dem Belichten wird die Resistschicht zur Schablone entwickelt und das freigelegte Kupfer geätzt (subtraktiv) oder galvanisch verstärkt und ggf. noch galvanisch mit Blei-Zinn-Legierung überzogen (semiadditives Verfahren). Die Resistschablone wird durch Entschichten entfernt, und -beim semiadditiven Verfahren -das Basiskupfer wird auf der Oberfläche und in den Löchern weggeätzt. Dabei ist es nicht erforderlich, das gesamte Basiskupfer zu entfernen. Es reicht aus, wenn die nicht benötigten Flächen des Basiskupfers durch Ätzen eines Zwischenraums von den Leiterzügen und Durchkontaktierungen getrennt werden. Das kann zweckmäßig wieder durch Abdecken mit einer geeigneten Photoresistschablone erfolgen. Das beschriebene "Trennätzen" hat den Vorteil, daß beim Verarbeiten wesentlich geringere Mengen an Kupferionen enthaltenden verbrauchten Ätzbädern anfallen. Die Belichtung unter der Vorlage hat passergenau im Hinblick auf die Lage der Löcher zu erfolgen. Das kann z. B. durch Anbringen von Markierungen am Rand der Platte und Ansteuern der Löcher, ausgehend von diesen Markierungen, erfolgen.

Durch das erfindungsgemäße Verfahren wird erreicht, daß vorgelochte Leiterplatten mit Metallkern mit gleichmäßigen, festhaftenden Isolierstoffüberzügen und festhaftenden Leitmetallschichten auch an den Innenwandungen der Durchkontaktierungslöcher bereitgestellt werden. Die Aufteilung der Isolierstoffbeschichtung und -härtung in zwei Härtungsmechanismen hat den Vorteil, daß ein Schmelzen und Verlaufen der Schicht während der thermischen Härtung durch die vorausgegangene Lichthärtung bzw. -vernetzung verhindert wird. Die eigentliche Verfestigung der Schichten und deren unlösbare Verbindung untereinander und mit der Metallunterlage wird dann durch die Wärmehärtung erreicht.

Die folgenden Beispiele erläutern bevorzugte Ausführungformen der Erfindung.

Beispiel 1

A Vorbereitung

Ein Aluminiumband von 0,3 mm Dicke wurde in Form eines wiederkehrenden Musters mit Löchern von 1 mm Durchmesser und 2,5 mm Lochabstand durch Stanzen versehen, wobei die gelochten Bezirke sich mit nichtgelochten Flächen abwechselten. Die Stanzgrate wurden durch Bürsten und die Rückstände des beim Stanzen verwendeten Öls durch Abwaschen mit Aceton entfernt. Das Band wurde nun beidseitig (einschließlich der Lochwandungen) in einer 1,6 % NaOH, 0,4 % $Na_2CO_3$ und 0,1 % $Na_3PO_4$ enthaltenden alkalischen Lösung bei 80°C 60-80 Sekunden gebeizt, in einem Salpetersäureelektrolyten (ca. 10 g/l $HNO_3$) bei 40°C, 20 A/dm² 17-20 Sekunden mit Wechselstrom von 20 Volt aufgerauht; dann im Schwefelsäurebad mit Gleichstrom anodisiert (40°C, 20 Volt, 24 A/dm², 150 g/l $H_2SO_4$; 4 g/m² Oxid auf jeder Seite).

Die Oxidschicht wurde durch Eintauchen in heißes Wasser (95°C; 1-2 Minuten) verdichtet.

Das Band wurde dann zu Platten zerschnitten.

B Isolierbeschichtung

Die Platten wurden in einer elektrostatischen Sprühbeschichtungsanlage mit der folgenden Lösung lackiert:

| | | |
|---|---|---|
| I Epoxidharz mit endständigen Acrylat-gruppen (65 % in Toluol) | 172 | Gew.-T. |
| Plastifiziertes Epoxidharz (Epoxid-Äquivalentgewicht ca. 450; dynamische Viskosität 10-15 Pa·s) | 100 | " " |
| Epoxidharz (Epoxid-Äquivalentgewicht 190) | 100 | Gew.-T. |
| Glycidylmethacrylat | 112 | " " |
| n-Butylmethacrylat | 22 | " " |
| Methylmethacrylat | 22 | " " |
| Hexahydrophthalsäureanhydrid | 182,8 | " " |
| Benzyltriethylammoniumchlorid | 1,5 | " " |
| 2-Hydroxy-2-methyl-1-phenyl-propan-1-on | 26 | " " |
| II Feinteilige Kieselsäure, | 100 | " " |
| dispergiert in | 900 | " " |
| Butanon durch Homogenisieren mit einem Hochgeschwindigkeitsrührer (Ultraturrax) | | |

| III Copolymeres von 62 % Butadien und 38 % Acrylnitril | 100 | Gew.-T. | |
|---|---|---|---|
| Xylol | 720 | " | " |
| Butanon | 180 | " | " |

Fertige Lösung:

| Lösung I | 145 | " | " |
|---|---|---|---|
| Suspension II | 126 | " | " |
| Lösung III | 150 | " | " |
| Xylol | 576 | " | " |

Die Bedingungen wurden so gewählt, daß auf jede Seite 12 g/m² aufgetragen wurden. Der Lack wurde unmittelbar nach dem Auftragen in einem kalten Luftstrom vorgetrocknet und dann 1 Minute der Strahlung einer Hg-Hochdrucklampe ausgesetzt, wobei die darin enthaltenen Monomeren polymerisierten. Die Schichten wurden dann noch 1 Minute bei 180°C teilgehärtet.

Dann wurden die Platten in einem wäßrigen kataphoretischen Tauchbad, das ein mit Säure neutralisiertes Epoxidharz-Amin-Addukt und einen aktivierte Estergruppen aufweisenden Oligoester in wäßriger Dispersion enthält (Feststoffgehalt: 12 %), bei 3 cm Elektrodenabstand, 125 V Gleichspannung und 28°C 2 Minuten behandelt, danach gespült und 3-5 Minuten bei 180°C teilweise ausgehärtet. Durch die kataphoretische Behandlung wurde eine Schicht mit einem Gewicht von 0,3 g/m² aufgebracht.

Die elektrostatische Beschichtung mit anschließender Teilhärtung wurde noch viermal wiederholt. Schließlich wurde der gesamte Überzug bei 180°C im Verlauf einer Stunde durchgehärtet. Die Isolierschicht der Platte hatte eine Dicke von 60 -65 μm.

C Chromsäureaufschluß

Zur weiteren Behandlung wurde die Platte zunächst naß abgebürstet und dann in bekannter Weise 1 Minute mit Butanon vorbehandelt, darauf mit 40°C warmer Chromschwefelsäure aufgerauht, mit Natriumbisulfit sorgfältig entgiftet, 3 Minuten mit 3 %iger Flußsäure und danach mit heißer Lauge behandelt. Die Platten wurden schließlich noch unter fließendem Wasser abgebürstet und dann mit heißem Wasser, das eine geringe Menge Komplexbildner enthielt, nachgewaschen. Soweit notwendig, wurde zwischen den einzelnen Schritten mit Wasser sorgfältig gespült.

D Chemische Kupferabscheidung

Die Platten wurden in einem handelsüblichen System von Bädern (Zinnchlorid, Palladiumchlorid, Beschleuniger, chemisches Kupferabscheidungsbad) behandelt und danach nochmals 15 Minuten bei 140°C gehalten.

Ergebnis

Die Platten tragen nun auf ihrer gesamten Oberfläche, einschließlich der Lochwandungen, eine Isolierstoffschicht und darauf einen gleichmäßigen, festhaftenden 0,3 μm dicken Überzug von Kupfer. Im Lötbad (255-260°C) konnten keine Ablösungserscheinungen beobachtet werden. Die Vermessung der Lochdurchmesser zeigte nach dem Isolieren und Verkupfern keine messbaren Abweichungen von der Kreisform der ursprünglichen Stanzlöcher. Sie waren nicht durch verlaufenden Lack elliptisch verformt; es konnte keine Tropfenbildung in den Löchern, keine Keilbildung oder Stundenglasform beobachtet werden. Der Lochdurchmesser war lediglich um die Gesamtdicke von Isolier- und Kupferschicht vermindert. Im Fall des vorliegenden Beispiels waren das 2 x ca. 60-65 μm.

Beispiel 2 (Vergleichsbeispiel)

Es wurde verfahren wie in Beispiel 1, jedoch wurde die Behandlung im kataphoretischen Tauchbad fortgelassen. Die Isolierstoffschichtdicke betrug ca. 60 μm.

Von mehreren Platten, die jeweils nach Beispiel 1 und Beispiel 2 gefertigt und danach mit Kupfer überzogen worden waren, wurden jeweils an einer Stelle die Kupferschicht und die Isolierschicht entfernt, so daß der Aluminiumkern freigelegt wurde. Durch Kontakte wurde nun die blanke Aluminiumstelle und der Kupferüberzug mit den Polen eines Regeltransformators verbunden, so daß zwischen dem Aluminiumkern und dem Kupferüberzug eine Spannung lag.

Bei den nach Beispiel 1 hergestellten Mustern konnte die Spannung auf mehr als 200 Volt erhöht werden, ohne daß ein Stromdurchschlag zwischen beiden Metallagen eintrat. Dagegen zeigten die nach Beispiel 2 hergestellten Platten schon bei Spannungen zwischen 30 und 70 V Stromdurchschläge, die sich durch lokales Verbrennen der Isolierschicht und Verschmelzen der Kupfer-und Aluminiumlagen, meist in der unmittelbaren Nähe von Lochrändern zu erkennen gaben.

In der folgenden Tabelle sind die Ergebnisse von Versuchen mit Platten angegeben, die nach Beispiel 1 (erfindungsgemäß) und nach Beispiel 2 - (Vergleich) hergestellt wurden. Bei den Versuchen a-d gemäß Beispiel 1 wurden zuerst unterschiedlich dicke Schichten elektrostatisch aufgesprüht; danach wurde eine dünne Schicht kataphoretisch abgeschieden und dann noch eine oder mehrere Schichten elektrostatisch aufgesprüht. Alle Schichten zeigten gute Lötbadbeständigkeit und Haftung.

Die Versuche e-g sind Vergleichsversuche gemäß Beispiel 2, d. h. ohne kataphoretische Abscheidung. Dementsprechend wurden hohe Stromdurchgänge schon bei niedriger Spannung gemessen. Auch in diesen Fällen waren Haftung und Lötbadbeständigkeit gut.

## Tabelle

| Versuch | Auftragsmenge g/m$^2$ | | Stromdurchgang | |
|---|---|---|---|---|
| | elektrostatisch | kataphoretisch | Volt | Amp. |
| a | 12 + 60 | 0,3 | 200 | 0 |
| b | 12 + 12 | 0,3 | 200 | 0 |
| c | 24 + 50 | 0,3 | 200 | 0 |
| d | 50 + 24 | 0,3 | 200 | 0 |
| e | 12 | 0 | 40-50 | 20 |
| f | 36 | 0 | 40-50 | 20 |
| g | 72 | 0 | 40-50 | 5 |

Beispiel 3 (Vergleichsbeispiel)

. Es wurde verfahren, wie in Beispiel 1 beschrieben, jedoch wurde die Isolierschicht in der Weise aufgebracht, daß die Platten zuerst einer kataphoretischen Tauchlackierung unterzogen und dann viermal elektrostatisch sprühbeschichtet wurden. Das Schichtgewicht der gesamten Isolierschicht war in diesem Falle um ca. 20 g/m² höher als in Beispiel 1. Die elektrische Durchschlagsfestigkeit war befriedigend.

Zur Prüfung der Lötbadbeständigkeit wurden nach Beispiel 1 und 3 hergestellte Muster galvanisch verstärkt, so daß Kupferschichten von ca. 35 μm erhalten wurden. Aus den Platten wurden 4 cm breite und ca. 10 cm lange Streifen geschnitten und diese 10 Sekunden in ein 255-260°C heißes Metallbad eingetaucht. Während die nach Beispiel 1 hergestellten Streifen den Versuch unbeschadet überstanden, zeigten die nach Beispiel 3 hergestellten Streifen blasige Ablösungen.

Aus den gemäß Beispiel 1 hergestellten galvanisch verstärkten Platten wurden 2 cm breite und ca. 8-10 cm lange Streifen geschnitten. An den Streifen wurde die Haftung der Kupferschichten geprüft, indem vorsichtig an einem Ende die Kupferschicht von der Isolierschicht abgetrennt wurde. Das abgelöste Ende wurde in einem Zug-Dehnungs-Meßgerät senkrecht zur Plattenfläche mit definierter Zuggeschwindigkeit abgezogen und die dazu erforderliche Zugkraft gemessen. Die Prüfung wurde sowohl vor als auch nach Einwirkung des Lötbads, wie vorstehend beschrieben, durchgeführt. In beiden Fällen wurden Haftkräfte von mindestens 25 N je 2 cm Streifenbreite gemessen.

Beispiel 4

Weiterverarbeitung nach dem Subtraktiv-Verfahren

Eine der nach Beispiel 1 A bis D hergestellten Platten wurde durch galvanische Abscheidung mit einem Kupferüberzug von 35 μm versehen; dann wurde auf beide Seiten mittels eines handelsüblichen Laminators eine Trockenresistfolie mit einer 25 μm dicken photopolymerisierbaren Schicht auflaminiert.

Jede Trockenresistfolie wurde unter einem Negativ eines Schaltbildes belichtet, die Trägerfolie vom Resist abgezogen und die Schicht mit einer wäßrig-alkalischen Lösung entwickelt, wobei die unbelichteten Schichtbezirke ausgewaschen wurden. Das freigelegte Kupfer wurde fortgeätzt.

Beispiel 5

Verarbeitung nach dem Semiadditiv-Verfahren

Eine nach Beispiel 1 A bis D hergestellte Platte wurde auf beiden Seiten mittels eines handelsüblichen Laminators mit einer Trockenresistfolie überzogen, deren photopolymerisierbare Resist-

schicht ca. 65μm dick war. Die Trockenresistfolien wurden unter einem Positiv des gewünschten Schaltungsbildes belichtet, die Trägerfolien von der Resistschicht abgezogen und die Schicht entwickelt, wobei die unbelichteten Schichtbezirke ausgewaschen wurden. Die freigelegten Kupferflächen und Löcher wurden in einem handelsüblichen Kupferbad gal-vanisch auf ca. 50μm verstärkt, dann wurde mit einem handelsüblichen Bleizinnbad auf dem Kupfer eine etwa 10μm dicke Schicht aus Blei-Zinn-Legierung galvanisch abgeschieden. Die Resistschablone wurde entfernt und das darunter freigelegte Basiskupfer fortgeätzt.

Beispiel 6

Verarbeitung nach dem Additiv-Verfahren

Eine nach Beispiel 1 A bis C hergestellte Platte wurde nach dem Chromsäureaufschluß und vor der chemischen Kupferabscheidung mit einer negativ arbeitenden Trockenresistfolie beidseitig laminiert, unter dem Positiv des gewünschten Schaltbildes belichtet, die Trägerfolie entfernt und die Resistschicht unter Auswaschen der nicht belichteten Schichtbezirke entwickelt. Wie unter D beschrieben, wurde die Platte nun in einem handelsüblichen System von Bädern (Zinnchlorid, Palladiumchlorid, Beschleuniger) behandelt. Dann wurde die Resistschablone entfernt, die Platte kurz in ca. 40°C warme verdünnte Schwefelsäure eingetaucht und gespült. Aus einem handelsüblichen Bad wurde stromlos Kupfer auf den mit Pd-Keimen beladenen Flächen und Lochwandungen abgeschieden.

Beispiel 7

Es wurde verfahren wie in Beispiel 1, A bis D. Lediglich die Dicke der eingesetzten Aluminiumplatte betrug 1 mm und der Durchmesser der Löcher 0,4 mm. Nach dem Aufbringen der Isolierschicht und der chemischen Kupferschicht war die Beschichtung der Lochwandung ca. 60μm dick und sehr gleichmäßig. Eine "Sanduhrform" wurde nicht beobachtet. Der ursprüngliche Lochdurchmesser von 0,4 mm hatte sich gleichmäßig auf ca. 0,28 mm verändert.

**Ansprüche**

1. Verfahren zur Herstellung eines elektrisch isolierenden Basismaterials für die Herstellung von gelochten durchkontaktierten Leiterplatten mit einem Metallkern, bei dem der vorgelochte Metallkern mit einem dünnen, gleichmäßigen, ununterbrochenen Überzug aus einem Isolierstoff überzogen und der Isolierstoff gehärtet wird, dadurch gekennzeichnet, daß man

a) durch ein elektrostatisches Sprühverfahren eine durch Strahlung oder Wärme polymerisierbare Isolierstoffschicht auf den Metallkern aufbringt und diese durch Bestrahlung oder Erwärmen unvollständig aushärtet,

b) den elektrostatisch beschichteten Metallkern in einem elektrophoretischen Tauchbad mit einer thermisch härtbaren Substanz behandelt, die abgeschiedene Substanz durch Erwärmen trocknet und unvollständig härtet und

c) schließlich den gesamten Isolierstoffüberzug thermisch vollständig aushärtet.

2. Verfahren nach Anspruch 1, dadurch gekennzeichnet, daß die polymerisierbare Isolierstoffschicht der Stufe (a) Verbindungen mit polymerisierbaren Gruppen, die durch Bestrahlung oder durch Erwärmen in Gegenwart eines Katalysators auf eine Temperatur, bei der die thermisch härtbare Substanz der Stufe (b) nicht vollständig aushärtet, polymerisiert werden können, und ferner Gruppen enthält, die bei einer höheren Temperatur vernetzen.

3. Verfahren nach Anspruch 1, dadurch gekennzeichnet, daß man nach dem Aufbringen des Überzugs (b) und vor dem Aushärten (c) mindestens einen weiteren Überzug durch ein elektrostatisches Sprühverfahren aufbringt.

4. Verfahren nach Anspruch 1, dadurch gekennzeichnet, daß man die unvollständige thermische Aushärtung der Isolierstoffschicht (a) oder des Überzugs (b) bei einer Temperatur im Bereich von 80 -120°C und die vollständige Aushärtung bei einer Temperatur im Bereich von 150 -250°C durchführt.

5. Verfahren nach Anspruch 1, dadurch gekennzeichnet, daß der Metallkern aus Aluminium oder einer Aluminiumlegierung besteht.

6. Verfahren nach Anspruch 5, dadurch gekennzeichnet, daß die Oberfläche des Aluminiums einschließlich der Lochwandungen gebeizt, aufgerauht, anodisch oxydiert und dann verdichtet wird.

7. Verfahren nach Anspruch 1, dadurch gekennzeichnet, daß der durch Elektrophorese aufgebrachte Isolierstoff ein Aminogruppen enthaltendes Epoxidharz und einen thermisch aktivierbaren Epoxidhärter enthält.

8. Verfahren nach Anspruch 1, dadurch gekennzeichnet, daß der elektrostatisch aufgesprühte Überzug eine radikalisch polymerisierbare Verbindung und einen durch Strahlung aktivierbaren Initiator für die radikalische Polymerisation enthält.

9. Verfahren nach Anspruch 8, dadurch gekennzeichnet, daß der elektrostatisch aufgesprühte Überzug ferner ein Epoxidharz und einen thermisch aktivierbaren Epoxidhärter enthält.

10. Verfahren nach Anspruch 1, dadurch gekennzeichnet, daß man nacheinander insgesamt mehr als je eine Schicht gemäß Stufe a) und Stufe b) in beliebiger Reihenfolge aufbringt.

11. Verfahren nach Anspruch 1, dadurch gekennzeichnet, daß man den Metallkern vor der Behandlung mit Löchern versieht, die in einem regelmäßigen Muster über die Oberfläche verteilt sind.

12. Elektrisch isolierendes Basismaterial für die Herstellung von gelochten durchkontaktierten Leiterplatten, bestehend aus einem vorgelochten Metallkern mit einem dünnen, gleichmäßigen, ununterbrochenen, gehärteten isolierenden Überzug, dadurch gekennzeichnet, daß der Überzug aus mindestens einer thermisch gehärteten Isolierstoffschicht und mindestens einer strahlungsvernetzten und thermisch gehärteten Isolierstoffschicht besteht.